# EUROPEAN PATENT SPECIFICATION

(11) **EP 4 002 437 B1**
(45) Date of publication and mention of the grant of the patent: **02.08.2023**
(21) Application number: 21773256.9
(22) Date of filing: 11.06.2021
(51) Int. Cl.: H01L 21/768, H01L 23/522

(54) **METHOD OF FORMING A CONTACT WINDOW STRUCTURE**
VERFAHREN ZUR HERSTELLUNG EINER KONTAKTÖFFNUNG
PROCÉDÉ DE FORMATION D'UNE FENÊTRE DE CONTACT

(30) Priority: 22.09.2020 CN 202011001855
(43) Date of publication of application: 25.05.2022
(73) Proprietor: Changxin Memory Technologies, Inc., Hefei City, Anhui 230000 (CN)
(72) Inventor: LIU, Jie, Hefei, Anhui 230000 (CN); WU, Ping-heng, Hefei, Anhui 230000 (CN); YING, Zhan, Hefei, Anhui 230000 (CN)
(74) Representative: Lavoix
(86) International application number: PCT/CN2021/099873
(87) International publication number: WO 2022/062485

(56) References cited:
- WO-A1-2018/063337
- CN-A- 1 956 184
- CN-A- 103 094 186
- CN-A- 104 658 962
- US-A1- 2004 046 251
- US-A1- 2005 042 878
- US-A1- 2018 068 899
- US-A1- 2018 090 511
- US-A1- 2018 294 225

## Description

### CROSS-REFERENCE TO RELATED APPLICATION

The disclosure is proposed based on and claims priority to Chinese patent application No. 202011001855.8, filed on September 22, 2020, entitled "CONTACT WINDOW STRUCTURE, METAL PLUG AND FORMING METHOD THEREOF, AND SEMICONDUCTOR STRUCTURE".

### TECHNICAL FIELD

The disclosure relates to the field of semiconductor, and in particular to a contact window structure, a metal plug and a forming method thereof, and a semiconductor structure.

### BACKGROUND

With the development of integrated circuit to super-large scale integrated circuits, the circuit density inside the integrated circuits is increasing, and the number of components included in the integrated circuits is also increasing. Such development makes the surface of a wafer unable to provide enough area to make required interconnecting wires.

In order to meet the requirement of interconnecting wires after scaling down of the components, the design of two or more layers of multi-layer metal interconnecting wires has become a commonly used method in the super large-scale integrated circuit technology. At present, the conduction between different metal layers or between a metal layer and a pad layer can be realized by a metal plug. As the integration of devices becomes higher and higher, the depth-to-width ratio of vias formed in the process of forming the metal plug continues to increase, which leads to compromised performance relative to the circuit requirements proposed by the designer.

US 2018/294225 A1 discloses a prior art method of forming contact holes with a high depth-to-width ratio.

### SUMMARY

A technical problem to be solved by embodiments of the disclosure is to provide a contact window structure, a metal plug and a forming method thereof to reduce a phenomenon that a critical size of a bottom of a via is greater than a critical size of a top of the via, and overcome the problem that a size of the via slightly shrinks in an etching process.

The present invention is defined in claim 1.

Compared with related technologies, the technical solution of the embodiments of the disclosure has the following advantages:

According to the method of forming a contact window structure of the embodiments of the disclosure, a target layer is provided; an annular pad is formed on a surface of the target layer, a central via, from which partial surface of the target layer is exposed, in the middle part of the annular pad; a dielectric layer covering the target layer and the annular pad is formed; the dielectric layer is etched to form an etch hole connected to the central via in the dielectric layer; and the annular pad is removed to form the contact window structure. Through forming the annular pad, in forming the contact window structure, after the annular pad is removed, a size of the central via may be enlarged, so that a size of a bottom of the contact window structure may be enlarged; and in forming the metal plug in the contact window structure, a contact area between a bottom of the metal plug and the target layer may be increased, and a contact resistance between the bottom of the metal plug and the target layer is reduced. Furthermore, due to the existence of the annular pad, a depth or depth-to-width ratio of the etch hole formed in the dielectric layer may be reduced, so that the difficulty of forming hole etching is reduced, and therefore, there is no need to increase the size of the etch hole to form the etch hole, or the size of the etch hole may even be reduced to improve the integration, that is, a size of a top of the formed contact window structure may be the same as or smaller than a size of a top formed according to a related technology, while the size of the bottom of the formed contact window structure is increased.

In some embodiments, a process of forming the annular pad may include: forming a columnar structure on the partial surface of the target layer; forming a pad material layer on a side wall and a top surface of the columnar structure as well as the partial surface of the target layer; removing the pad material layer on the top surface of the columnar structure and the partial surface of the target layer by etching without a mask, to form the annular pad on a surface of the side wall of the columnar structure; and removing the columnar structure after forming the annular pad. The annular pad formed by such method has high precision in size and shape, and has a relative high side wall morphology.

In some embodiments, the process of forming the annular pad may include: forming a mask material layer on a substrate and the partial surface of the target layer, a first via, from which the partial surface of the target layer is exposed, is formed in the mask material layer; forming a pad material layer on a side wall and a bottom surface of the first via as well as a surface of the mask material layer; and removing the pad material layer on the surface of the mask material layer and the bottom surface of the first via by etching without a mask, to form the annular pad on a surface of the side wall of the first via. The annular pad formed by such method has high precision in size and shape, and has a relative high side wall morphology.

According to the contact window structure of the embodiments of the disclosure, the size of the bottom of the contact window structure may be enlarged; and in forming the metal plug in the contact window structure, the contact area between the bottom of the metal plug and the target layer may be increased, and the contact resistance between the bottom of the metal plug and the target layer is reduced.

### BRIEF DESCRIPTION OF THE DRAWINGS

FIG. 1 illustrates a schematic diagram of a structure of a via formed according to the related technology.
FIG. 2 to FIG. 14 illustrate schematic diagrams of cross-section structures in a process of forming a contact window structure according to embodiments of the disclosure.

### DETAILED DESCRIPTION

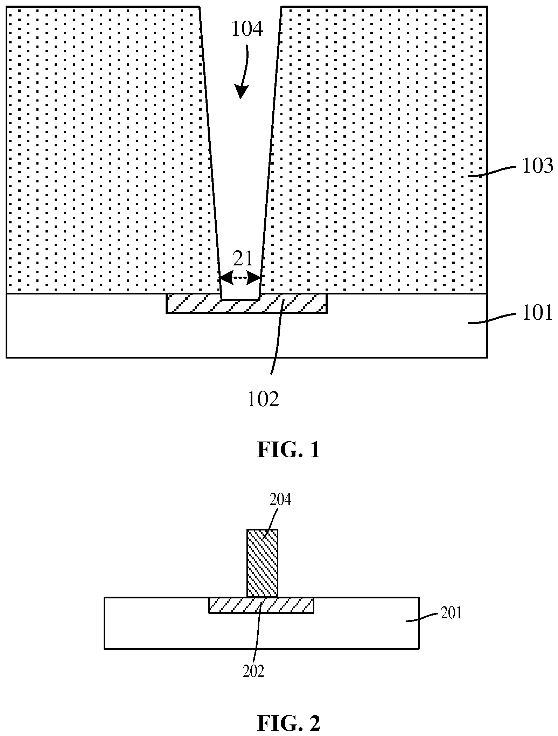

With reference to FIG. 1, the process of forming a metal plug in the related technology includes the following steps. A target metal layer 102 is formed in a substrate 101, and the target metal layer 102 is flush with a surface of the substrate 101. A dielectric layer 103 is formed on the substrate 101 and the target metal layer 102. A via (or a contact window structure) 104, from which a surface of the target metal layer is exposed, is formed in the dielectric layer 103. The via (or the contact window structure) is filled with metal (not shown in the figure) to form the metal plug (not shown in the figure).

As the integration of devices becomes higher and higher, a depth-to-width ratio of vias formed in the dielectric layer continues to increase, and the via with high depth-to-width ratio is a big challenge for the etching process. Generally, in a downward etching process, the via gradually narrows, and a critical size 21 of a bottom of the via 104 is smaller than a critical size of a top of the via 104. In this slight shrinkage process, the performance of the circuit may be compromised relative to circuit requirements proposed by the designer. In addition, the window size in the bottom layer of the via usually limit a resistance value of the whole contact window, and the slightly shrunk size may greatly reduce the contact area with the target metal layer. As stated in the background, a slight shrink phenomena may occur in the existing process for forming the via, especially for the via with a high depth-to-width ratio, and this phenomena results in that the size of the bottom of the via is smaller than that of the top of the via, and the contact resistance is increased.

Therefore, the embodiments of the disclosure provide a contact window structure, a metal plug and a forming method thereof, as well as a semiconductor structure. The method of forming the contact window structure includes the following steps. A target layer is provided. An annular pad is formed on a surface of the target layer, and a central via, from which partial surface of the target layer is exposed, in the middle part of the annular pad. A dielectric layer covering the target layer and the annular pad is formed. The dielectric layer is etched to form an etch hole connected to the central via in the dielectric layer. The annular pad is removed to form the contact window structure. Through forming the annular pad, in forming the contact window structure, after the annular pad is removed, a size of the central via may be enlarged, so that a size of a bottom of the contact window structure may be enlarged; and in forming the metal plug in the contact window structure, a contact area between a bottom of the metal plug and the target layer may be increased, and a contact resistance between the two is reduced. Furthermore, due to the existence of the annular pad, a depth or depth-to-width ratio of the etch hole formed in the dielectric layer may be reduced, so that the difficulty in forming hole etching is reduced, and therefore, in forming the etch hole, there is no need to increase the size of the etch hole or even may reduce the size of the etch hole to improve the integration, that is, a size of a top of the formed contact window structure may be the same as or smaller than a size of a top formed according to the related technology, while the size of the bottom of the formed contact window structure is increased.

In order to make the objectives, features and advantages of the embodiments of the disclosure more apparent and understandable, specific implementation of the disclosure will be described in detail below in combination with the drawings.

When describing the embodiments of the present disclosure in detail, for ease of description, the schematic diagrams will not be partially enlarged according to a general scale, and the schematic diagrams are only examples, which should not limit the protection scope of the embodiments of the present disclosure herein. Respective to describing the embodiments of the disclosure in detail, for ease of description, the schematic diagrams will be partially enlarged at a non-normal scale, and the schematic diagrams are only examples, which should not limit the protection scope of the embodiments of the disclosure herein. Furthermore, a three-dimensional space size of length, width and depth should be included in practical manufacturing.

Referring to FIG. 2, a substrate 201 is provided. A target layer 202 is formed in the substrate 201, and the substrate 201 exposes a surface of the target layer 202.

In some embodiments, the substrate 201 may be a semiconductor substrate. The target layer 202 may be a doped region (for example, a region doped with N-type impurity ions or doped with P-type impurity ions) located in the semiconductor substrate or a metal silicide region (for example, a nickel silicide region or a cobalt silicide region) located in the semiconductor substrate. The semiconductor substrate may be made of silicon (Si), germanium (Ge) or silicon-germanium (GeSi), silicon carbide (SiC); or may be Silicon-on-Insulator (SOI), Germanium-on-Insulator (GOI); or may be other materials, for example, group III-V compounds such as gallium arsenide.

In other embodiments, the substrate 201 may include the semiconductor substrate and an interlevel dielectric layer located on the semiconductor substrate, and the target layer 202 is located in the interlevel dielectric layer. The interlevel dielectric layer may have a monolayer or multilayer stack structure, the target layer 202 may be a metal layer, and the metal layer may be connected with a conductive structure (for example, a conductive plug) formed in the lower dielectric layer.

The surface of the target layer 202 may be flush with a surface of the substrate 201, or is slightly higher than the surface of the substrate 102.

There may be one or more (greater than or equal to 2) target layers 202 formed in the substrate 201. When there are multiple target layers 202, adjacent target layers are separated from each other. The substrate 201 with only one target layer 202 is illustrated as an example in this embodiment.

An annular pad is to be formed on the target layer 202 subsequently. For the subsequent forming of the annular pad, in one embodiment, a columnar structure 204 is formed on partial surface of the target layer 202.

The columnar structure 204 determines a position and a shape of the subsequently formed annular pad. The columnar structure may be of a cylindrical shape or an elliptic cylindrical shape, or other suitable shapes (a cube shape or an oblong shape). A bottom area of the columnar structure 204 is smaller than an area of the target layer 202.

A material of the columnar structure 204 may be different from materials of the target layer 202, the substrate 201 and the subsequently formed annular pad. In the subsequent process of removing the columnar structure 204, the columnar structure 204 has a higher etch selectivity ratio than that for the target layer 202, the substrate 201 and the annular pad, and etching damage to the target layer 202, the substrate 201 and the annular pad is reduced or prevented.

The columnar structure 204 may be made of a photoresist material or a mask material. The mask material may be one or more of silicon nitride, silicon oxide, silicon carbonitride, silicon oxynitride, polysilicon, amorphous silica, amorphous carbon and low-K dielectric material.

In one embodiment, the columnar structure 204 is made of the photoresist material, and the process of forming the columnar structure 204 includes the following steps. A photoresist layer is formed on the substrate 201 and the target layer 202. The photoresist layer is subjected to exposure and development to form the columnar structure on the target layer 202.

In another embodiment, the columnar structure 204 is made of the mask material, and the process of forming the columnar structure 204 includes the following steps. A mask material layer is formed on the substrate 201 and the target layer 202. The mask material layer is subjected to etching to form the columnar structure on the target layer 202.

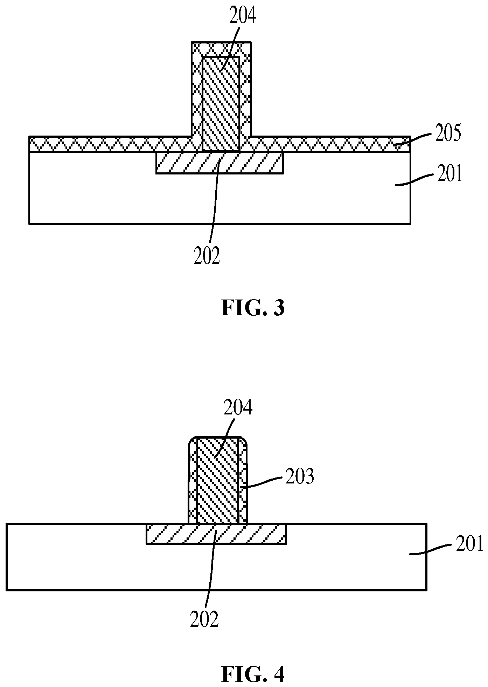

Referring to FIG. 3, a pad material layer 205 is formed on a side wall and a top surface of the columnar structure 204, the substrate 201 and partial surface of the target layer 202.

The pad material layer 205 is subsequently used for forming the annular pad. The pad material layer 205 is made of a material different from that of the subsequently formed dielectric layer. In forming an etching hole in the dielectric layer subsequently, the dielectric layer has a higher etch selectivity ratio relative to that of the annular pad.

The pad material layer 205 may be made of one or more of silicon nitride, silicon oxide, silicon carbonitride and silicon oxynitride. The pad material layer is formed by using a chemical vapor deposition process.

A thickness of the pad material layer 205 determines a width of the subsequently formed annular pad and an enlarged size of a central via. The thickness of the pad material layer is 3 times or more of the size of the columnar structure or the subsequently formed central via. At the forgoing specific proportion, a size of a bottom of the central via may be efficiently enlarged in the subsequent process, so as to enable the central via to meet practical requirements. The thicker the deposited pad material layer is, the larger the size and area of the window after the pad material is removed is.

Referring to FIG. 4, the pad material layer on the top surface of the columnar structure 204 as well as the substrate 201 and the partial surface of the target layer 202 is removed by etching without a mask, to form an annular pad 203 on a surface of the side wall of the columnar structure 204.

The pad material layer is etched by an anisotropic dry etching process, which may be a plasma etching process.

Through the formed annular pad 203, in the subsequent process of forming a contact window structure, when the annular pad is removed, the size of the central via may be enlarged, so that the size of the bottom of the contact window structure may be enlarged; and in forming a metal plug in the contact window structure, a contact area between a bottom of the metal plug and the target layer may be increased, and a contact resistance between the bottom of the metal plug and the target layer is reduced. Furthermore, due to the existence of the annular pad, a depth or depth-to-width ratio of the etch hole formed in the dielectric layer may be reduced, so that the difficulty of forming hole etching is reduced, and therefore, there is no need to increase the size of the etch hole to form the etch hole, or the size of the etch hole may even be reduced to improve the integration. That is, a size of a top of the formed contact window structure may be the same as or smaller than a size of a top formed according to the related technology, while the size of the bottom of the formed contact window structure is increased.

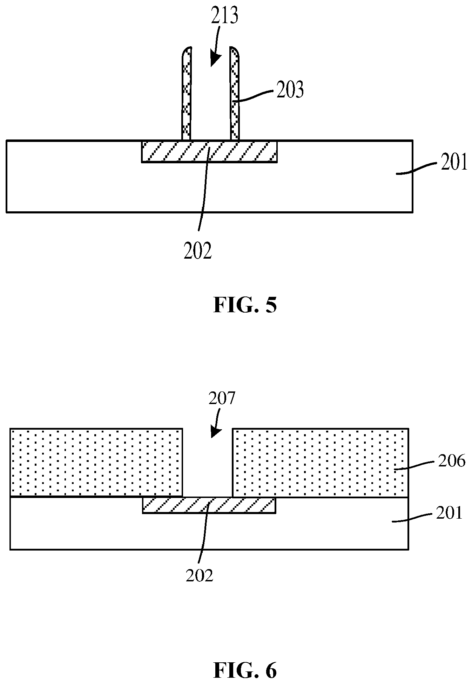

Referring to FIG. 5, the columnar structure is removed. A central via 213 is formed in the middle part of the annular pad 203, and partial surface of the target layer 202 is exposed from the central via 213.

The columnar structure may be removed by wet etching or dry etching. In removing the columnar structure, an etch solution or etch gas with a higher etch selectivity ratio is used for the columnar structure relative to that for the annular pad 203, the target layer 202 and the substrate 201.

Another embodiment of the disclosure further provides a method of forming the annular pad 203. Referring to FIG. 6 to FIG. 8, first refer to FIG. 6, a mask material layer 206 is formed on the substrate 201 and partial surface of the target layer 202. A first via 207, from which the partial surface of the target layer is exposed, 202 is formed in the mask material layer 206.

The mask material layer 206 may be made of one or more of photoresist, silicon nitride, silicon oxide, silicon carbonitride, silicon oxynitride, polysilicon, amorphous silica, amorphous carbon and low-K dielectric material. The mask material layer 206 may be formed by using the chemical vapor deposition process.

In one embodiment, the mask material layer 206 is made of a photoresist material, and the first via 207 is formed in the mask material layer 206 by exposure and developing processes. When the mask material layer 206 is made of other materials, the first via 207 may be formed in the mask material layer 206 by an etching process.

A shape and a position of the first via 207 determines a shape and a position of the subsequently formed annular pad.

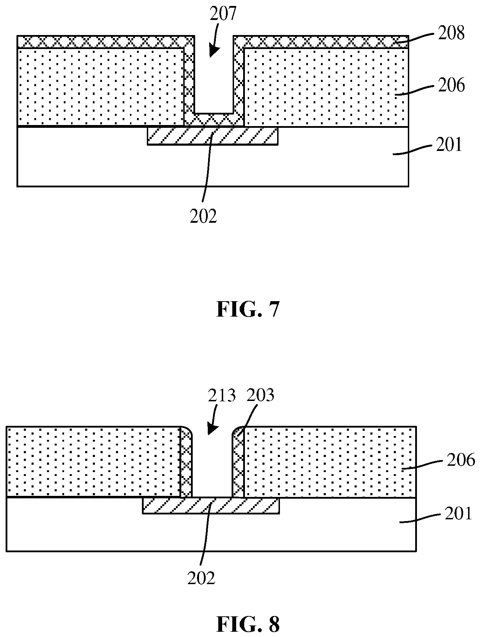

Referring to FIG. 7, a pad material layer 208 is formed on a side wall and a bottom surface of the first via 207 as well as a surface of the mask material layer 206.

The pad material layer 208 is subsequently used for forming the annular pad. The pad material layer 208 is made of a material different from that of a subsequently formed dielectric layer. In forming an etching hole in the dielectric layer subsequently, the dielectric layer has a higher etch selectivity ratio that that of the annular pad.

The pad material layer 208 may be made of one or more of silicon nitride, silicon oxide, silicon carbonitride and silicon oxynitride. The pad material layer is formed by using the chemical vapor deposition process.

A thickness of the pad material layer 208 determines a width of the subsequently formed annular pad and an enlarged size of a central through hole. In one embodiment, the thickness of the pad material layer 208 is 3 times or more of the size of the columnar structure or the subsequently formed central via.

Referring to FIG. 8, the pad material layer on the surface of the mask material layer 206 and the bottom surface of the first via is etched without a mask and removed to form the annular pad 203 on a surface of the side wall of the first via. The central via 213 is formed in the middle part of the annular pad 203.

The pad material layer is etched by an anisotropic dry etching process, which may be a plasma etching process.

In one embodiment, the mask material layer 206 is removed after forming the annular pad 203. The mask material layer 206 may be removed by a wet etching process or a dry etching process.

In another embodiment, if the mask material layer 206 is made of an isolation material and may be used for electrical isolation between devices, for example, when the mask material layer is made of a material the same as that of the subsequently formed dielectric layer, after the annular pad 203 is formed, the mask material layer 206 is retained, and the dielectric layer is directly formed on the mask material layer 206 subsequently, so that there is no need of an additional step to remove the mask material layer 206.

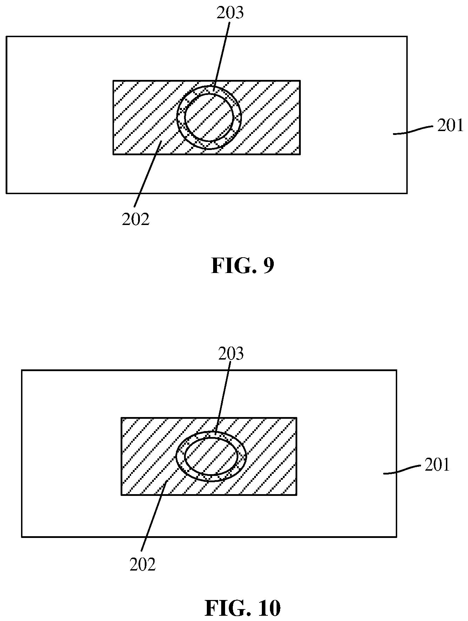

Referring to FIG. 9 and FIG. 10, FIG. 9 and FIG. 10 are top schematic diagrams of the structure of the foregoing formed annular pad 203. The annular pad 203 shown in FIG. 9 is of a circular ring shape, which facilitate the design of the contact window structure. The annular pad 203 shown in FIG. 10 is of an elliptic shape, which may reduce a resistance of a metal plug formed in the contact window structure subsequently. In other embodiments, which are not part of the present invention, the pad may be of a strip shape, which may reduce the resistance of the metal plug formed in the contact window structure subsequently.

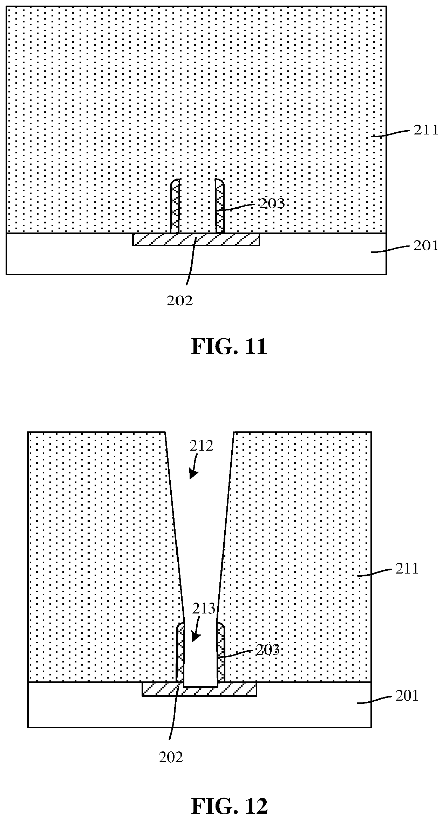

Referring to FIG. 11, FIG. 11 is carried out on the basis of FIG. 5. A dielectric layer 211 is formed covering the substrate 201, the target layer 202 and the annular pad 203.

The dielectric layer 211 is made of a material different from that of the annular pad 203. The dielectric layer 211 may be made of one of silicon nitride, silicon oxide, silicon carbonitride and silicon oxynitride.

The dielectric layer 211 is formed by chemical vapor deposition. In one embodiment, the dielectric layer 211 may be flattened by a flattening process, such that the dielectric layer 211 has a flat surface. The flattening process may be a chemical mechanical grinding process.

In one embodiment, the central via in the middle part of the annular pad 203 may be fully filled with the formed dielectric layer 211. In another embodiment, the central via may be partially filled or not filled with the dielectric layer 211. An air gap is formed in the annular pad. After the subsequent step of forming the etch hole in the dielectric layer, when continuing downward etching, it is very easy to expose the central via in the middle part of the annular pad 203 again, so as to prevent the influence on the size of the etch hole due to excessive long etching time. In one embodiment, the air gap is formed by adjusting a step coverage rate of a depositing process during forming of the dielectric layer 211.

In another embodiment, before the dielectric layer is formed, the central via in the middle part of the annular pad 203 may be filled with a sacrificial layer. In a subsequent step of etching the dielectric layer to form the etch hole, an etching rate of the sacrificial layer is greater than an etching rate of the dielectric layer, so that it is also very easy to expose the central via in the annular pad 203 again, so as to prevent the influence on the size of the etch hole due to excessive long etching time. In one embodiment, when the dielectric layer material is silicon oxide, the sacrificial layer may be made of a semiconductor insulation material such as silicon nitride, silicon oxynitride, silicon carbonitride or silicon oxycarbide. Referring to FIG. 12, the dielectric layer 211 is etched, to form an etch hole 212 connected to the central via 213 in the dielectric layer 211.

In one embodiment, before the dielectric layer 211 is etched, a patterned mask layer (for example, a patterned photoresist layer or a stack structure of patterned hard mask layers and photoresist layers) is formed on the dielectric layer 211. The patterned mask layer is used as a mask to etch the dielectric layer 211.

After the etch hole 212 is formed, a material (for example, a dielectric layer material or a sacrificial layer material) filled in the central via 213 in the bottom of the etch hole 212 is continuously etched, so as to expose the central via 213 again and enable the etch hole 212 to be connected to the central via 213.

In one embodiment, the etch hole 212 formed in the dielectric layer 211 still has a high depth-to-width ratio, so that the size of the top of the formed etch hole 212 will be smaller than that of the bottom of the etch hole 212, that is, in a direction from an upper surface to a lower surface of the dielectric layer 211, the size of the etch hole 212 is gradually reduced. In other embodiments, the size of the top of the etch hole and the size of the bottom of the etch hole may be the same.

In one embodiment, the dielectric layer 211 may be etched by an anisotropic dry etching process, such as an anisotropic plasma etching process. For etching the dielectric layer 211 to form the etch hole 212, the dielectric layer 211 has a high etch selectivity ratio relative to the annular pad 203 (a specific etch selectivity ratio may be greater than or equal to 2:1). A bottom position of the etch hole 212 may be defined by the annular pad 203, and a diameter of the bottom of the etch hole 212 is smaller than an outer diameter of the annular pad 203.

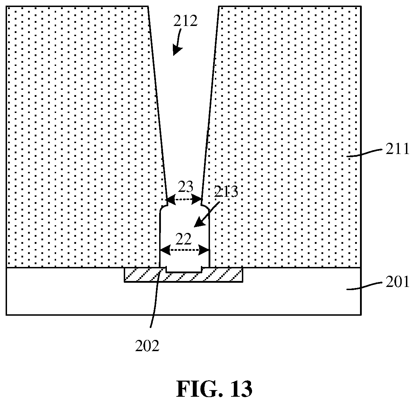

Referring to FIG. 13, the annular pad 203 is removed along the etch hole 212 and the central via 213 (referring to FIG. 12) to enlarge the size of the central via 213, and the contact window structure is formed by the etch hole 212 and the central via 213 with the enlarged size.

The annular pad may be removed by an isotropic wet or dry etching process. In one embodiment, when the material of the annular pad 203 is silicon nitride, the annular pad 203 is removed by wet etching. An etching solution used for the wet etching is hot phosphoric acid.

After the etched pad is removed, the size of the central via 213 is enlarged, such that a size 22 of the central via 213 will be greater than a size 23 of the bottom of the etch hole 212, that is, the size of the bottom of the formed contact window is increased relative to the size of the bottom of the contact window structure formed according to the related technology. In a subsequent process of forming a metal plug in the contact window structure, a contact area between a bottom of the metal plug and the target layer may be increased, and a contact resistance between the bottom of the metal plug and the target layer is reduced.

In one embodiment, in the process of forming the contact window, the target layer 202 is partially etched.

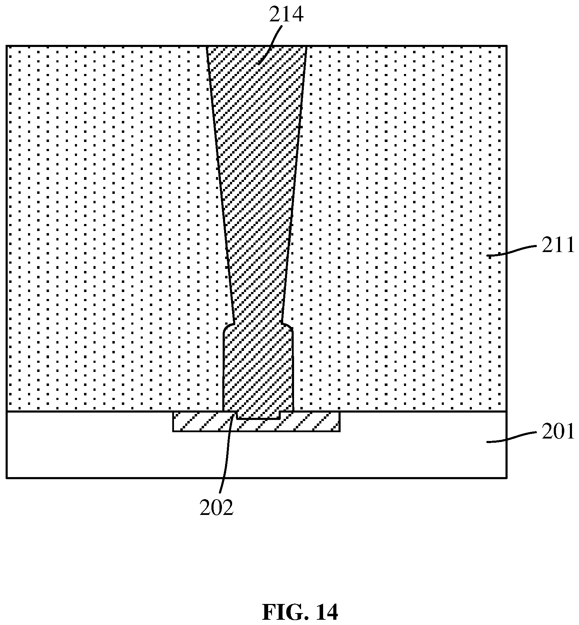

In one embodiment, referring to FIG. 14, after the contact window structure is formed, the contact window structure is filled with metal to form a metal plug 214.

The metal plug 214 is made of metal or other suitable conductive materials.

In one embodiment, a process of forming the metal plug 214 includes the following steps. A conductive material layer is formed on the contact window structure and a surface of the dielectric layer 211. The contact window structure is fully filled with the conductive material layer. The conductive material layer may be formed from metal (for example, tungsten) through a sputtering process. The conductive material layer higher than the surface of the dielectric layer 211 is removed by a chemical mechanical grinding process, and the metal plug 214 is formed in the contact window structure.

In another embodiment, after the contact window structure is formed, a capacitor structure is formed in the contact window structure.

A semiconductor structure is illustrated. Referring to FIG. 12, the semiconductor structure includes a target layer 202, an annular pad 203, a dielectric layer 211 and an etch hole 212.

The annular pad 203 is located on a surface of the target layer 202, and a central via 213, from which partial surface of the target layer 202 is exposed, is formed in the middle part of the annular pad 203.

The dielectric layer 211 covers the target layer 202 and the annular pad 203.

The etch hole 212 is located in the dielectric layer 211 and is connected to the central via 213.

It should be noted that definition or description of similar or same structures in the semiconductor structure and the forgoing embodiments (the forming process of the contact window structure) will not be defined. Referring to the definition or description in the corresponding sections of the foregoing embodiments for details.

A contact window structure is illustrated. Referring to FIG. 13, the contact window structure includes a target layer 202, a dielectric layer 211 and a contact window.

The dielectric layer 211 is located on the target layer 202.

The contact window is located in the dielectric layer 211. The contact window includes an etch hole 212 and a central via 213 connected to each other. The etch hole 212 is located above the central via 213. Partial surface of the target layer is exposed from the central via 213. A size of the central via 213 is greater than that of a bottom of the etch hole 212.

It should be noted that definition or description of similar or same structures in the contact window structure and the forgoing embodiments (the forming process of the contact window structure) will not be defined. Referring to the definition or description in the corresponding sections of the foregoing embodiments for details.

A metal plug is illustrated. Referring to FIG. 14, the metal plug includes a target layer 202, a dielectric layer 211, a contact window and a metal plug 214.

The dielectric layer 211 is located on the target layer 202.

The contact window is located in the dielectric layer 211. The contact window includes an etch hole 212 (referring to FIG. 13) and a central via 213 (referring to FIG. 13) connected to each other. The etch hole 212 is located above the central via 213. Partial surface of the target layer is exposed from the central via 213. A size of the central via 213 is greater than that of a bottom of the etch hole 212.

The contact window is filled with the metal plug 214.

It should be noted that definition or description of similar or same structures in the metal plug and the forgoing embodiments (the process of forming the contact window structure) will not be defined. Referring to the definition or description in the corresponding sections of the foregoing embodiments for details. greater than or equal to 2:1). A bottom position of the etch hole 212 may be defined by the annular pad 203, and a diameter of the bottom of the etch hole 212 is smaller than an outer diameter of the annular pad 203.

Referring to FIG. 13, the annular pad 203 is removed along the etch hole 212 and the central via 213 (referring to FIG. 12) to enlarge the size of the central via 213, and the contact window structure is formed by the etch hole 212 and the central via 213 with the enlarged size.

The annular pad may be removed by an isotropic wet or dry etching process. In one embodiment, when the material of the annular pad 203 is silicon nitride, the annular pad 203 is removed by wet etching. An etching solution used for the wet etching is hot phosphoric acid.

After the etched pad is removed, the size of the central via 213 is enlarged, such that a size 22 of the central via 213 will be greater than a size 23 of the bottom of the etch hole 212, that is, the size of the bottom of the formed contact window is increased relative to the size of the bottom of the contact window structure formed according to the related technology. In a subsequent process of forming a metal plug in the contact window structure, a contact area between a bottom of the metal plug and the target layer may be increased, and a contact resistance between the bottom of the metal plug and the target layer is reduced.

In one embodiment, in the process of forming the contact window, the target layer 202 is partially etched.

In one embodiment, referring to FIG. 14, after the contact window structure is formed, the contact window structure is filled with metal to form a metal plug 214.

The metal plug 214 is made of metal or other suitable conductive materials.

In one embodiment, a process of forming the metal plug 214 includes the following steps. A conductive material layer is formed on the contact window structure and a surface of the dielectric layer 211. The contact window structure is fully filled with the conductive material layer. The conductive material layer may be formed from metal (for example, tungsten) through a sputtering process. The conductive material layer higher than the surface of the dielectric layer 211 is removed by a chemical mechanical grinding process, and the metal plug 214 is formed in the contact window structure.

In another embodiment, after the contact window structure is formed, a capacitor structure is formed in the contact window structure.

The embodiments of the disclosure further provide a semiconductor structure. Referring to FIG. 12, the semiconductor structure includes a target layer 202, an annular pad 203, a dielectric layer 211 and an etch hole 212.

The annular pad 203 is located on a surface of the target layer 202, and a central via 213, from which partial surface of the target layer 202 is exposed, is formed in the middle part of the annular pad 203.

The dielectric layer 211 covers the target layer 202 and the annular pad 203.

The etch hole 212 is located in the dielectric layer 211 and is connected to the central via 213.

It should be noted that definition or description of similar or same structures in the present embodiment (the semiconductor structure) and the forgoing embodiments (the forming process of the contact window structure) will not be defined in the present embodiment. Referring to the definition or description in the corresponding sections of the foregoing embodiments for details.

Another embodiment of the disclosure further provides a contact window structure. Referring to FIG. 13, the contact window structure includes a target layer 202, a dielectric layer 211 and a contact window.

The dielectric layer 211 is located on the target layer 202.

The contact window is located in the dielectric layer 211. The contact window includes an etch hole 212 and a central via 213 connected to each other. The etch hole 212 is located above the central via 213. Partial surface of the target layer is exposed from the central via 213. A size of the central via 213 is greater than that of a bottom of the etch hole 212.

It should be noted that definition or description of similar or same structures in the present embodiment (the contact window structure) and the forgoing embodiments (the forming process of the contact window structure) will not be defined in the present embodiment. Referring to the definition or description in the corresponding sections of the foregoing embodiments for details.

Another embodiment of the disclosure further provides a metal plug. Referring to FIG. 14, the metal plug includes a target layer 202, a dielectric layer 211, a contact window and a metal plug 214.

The dielectric layer 211 is located on the target layer 202.

The contact window is located in the dielectric layer 211. The contact window includes an etch hole 212 (referring to FIG. 13) and a central via 213 (referring to FIG. 13) connected to each other. The etch hole 212 is located above the central via 213. Partial surface of the target layer is exposed from the central via 213. A size of the central via 213 is greater than that of a bottom of the etch hole 212.

The contact window is filled with the metal plug 214.

[**00120]** It should be noted that definition or description of similar or same structures in the present embodiment (the metal plug) and the forgoing embodiments (the process of forming the contact window structure) will not be defined in the present embodiment. Referring to the definition or description in the corresponding sections of the foregoing embodiments for details. Although the embodiments of the disclosure have been disclosed as above in preferred embodiments, they are not intended to limit the embodiments of the disclosure. Any person skilled in the art may use the above disclosed method and technical contents to make possible changes and variations to the technical solution of the embodiments of the disclosure without departing from the spirit and scope of the embodiments of the disclosure. Therefore, any content that does not depart from the technical solutions of the embodiments of the disclosure, any simple variations, equivalent changes and modification made to the above embodiments based on the technical essence of the embodiments of the disclosure all fall within the protection scope of the technical solutions of the embodiments of the disclosure.

## Claims

1. A method of forming a contact window structure, comprising:
providing a target layer (202);
forming an annular pad (203) on a surface of the target layer, wherein a central via (213), from which a partial surface of the target layer is exposed, is formed in a middle part of the annular pad;
forming a dielectric layer (211) covering the target layer and the annular pad;
etching the dielectric layer to form an etch hole (212) connected to the central via in the dielectric layer; and
removing the annular pad to form the contact window structure.

2. The method of forming the contact window structure of claim 1, wherein forming the annular pad comprises:
forming a columnar structure (204) on the partial surface of the target layer;
forming a pad material layer (205) on a side wall and a top surface of the columnar structure as well as the partial surface of the target layer;
removing the pad material layer on a top surface of the columnar structure and the partial surface of the target layer by etching, to form the annular pad (203) on a surface of the side wall of the columnar structure; and
removing the columnar structure.

3. The method of forming the contact window structure of claim 1, wherein forming the annular pad comprises:
forming a mask material layer (206) on the partial surface of the target layer, wherein a first via (207), from which the partial surface of the target layer is exposed, is formed in the mask material layer;
forming a pad material layer (208) on a side wall and a bottom surface of the first via as well as a surface of the mask material layer; and
removing the pad material layer on the surface of the mask material layer and the bottom surface of the first via by etching, to form the annular pad (203) on a surface of the side wall of the first via.

4. The method of forming the contact window structure of claim 3, further comprising:
after forming the annular pad, removing the mask material layer to form a dielectric layer on the target layer and the annular pad, or
after forming the annular pad, retaining the mask material layer and forming a dielectric layer on the mask material layer.

5. The method of forming the contact window structure of claim 1, wherein in forming the dielectric layer, the central via in the middle part of the annular pad is fully filled with the formed dielectric layer.

6. The method of forming the contact window structure of claim 1, wherein in forming the dielectric layer, the central via is partially filled or not filled with the dielectric layer, and an air gap is formed in the annular pad.

7. The method of forming the contact window structure of claim 1, further comprising:
before forming the dielectric layer, filling the central via in the middle part of the annular pad with a sacrificial layer, wherein in etching the dielectric layer to form the etch hole, an etching rate for the sacrificial layer is greater than an etching rate for the dielectric layer.

8. The method of forming the contact window structure of claim 1, wherein a thickness in radial direction of the annular pad is 3 times or more of a size of the central via, the size of the central via being a diameter of the central via

9. The method of forming the contact window structure of claim 1, wherein in a process of forming the contact window, the target layer is partially removed by etching.

10. The method of forming the contact window structure of claim 1, further comprising:
providing a substrate, wherein the target layer is formed in the substrate, and a surface of the target layer is exposed from the substrate.

11. A method of forming a metal plug, comprising:
forming a contact window structure using the method of any one of claims 1 to 10; and
filling the contact window structure with metal to form the metal plug (214).

## Patentansprüche

1. Verfahren zum Bilden einer Kontaktfensterstruktur, umfassend:
Bereitstellen einer Zielschicht (202);
Bilden eines ringförmigen Pads (203) auf einer Oberfläche der Zielschicht, wobei ein mittlerer Durchkontaktierung (213), von dem aus eine Teilfläche der Zielschicht freigelegt wird, in einem mittleren Teil des ringförmigen Pads gebildet ist;
Bilden einer dielektrischen Schicht (211), die die Zielschicht und das ringförmige Pad bedeckt;
Ätzen der dielektrischen Schicht, um ein Ätzloch (212) zu bilden, das mit der mittleren Durchkontaktierung in der dielektrischen Schicht verbunden ist; und Entfernen des ringförmigen Pads, um die Kontaktfensterstruktur zu bilden.

2. Verfahren zum Bilden der Kontaktfensterstruktur nach Anspruch 1, wobei ein Bilden des ringförmigen Pads Folgendes umfasst:
Bilden einer säulenartigen Struktur (204) auf der Teiloberfläche der Zielschicht;
Bilden einer Pad-Materialschicht (205) auf einer Seitenwand und einer oberen Oberfläche der säulenförmigen Struktur sowie auf der Teilfläche der Zielschicht;
Entfernen der Pad-Materialschicht auf einer oberen Oberfläche der säulenförmigen Struktur und der Teiloberfläche der Zielschicht durch Ätzen, um das ringförmige Pad (203) auf einer Oberfläche der Seitenwand der säulenförmigen Struktur zu bilden; und Entfernen der säulenförmigen Struktur.

3. Verfahren zum Bilden der Kontaktfensterstruktur nach Anspruch 1, wobei ein Bilden des ringförmigen Pads Folgendes umfasst:
Bilden einer Maskenmaterialschicht (206) auf der Teiloberfläche der Zielschicht, wobei eine erste Durchkontaktierung (207), von der aus die Teiloberfläche der Zielschicht freigelegt wird, in der Maskenmaterialschicht gebildet ist;
Bilden einer Pad-Materialschicht (208) auf einer Seitenwand und einer Bodenfläche der ersten Durchkontaktierung sowie einer Oberfläche der Maskenmaterialschicht; und Entfernen der Pad-Materialschicht auf der Oberfläche der Maskenmaterialschicht und der Bodenfläche der ersten Durchkontaktierung durch Ätzen, um das ringförmige Pad (203) auf einer Oberfläche der Seitenwand der ersten Durchkontaktierung zu bilden.

4. Verfahren zum Bilden der Kontaktfensterstruktur nach Anspruch 3, ferner umfassend:
nach Bilden des ringförmigen Pads, Entfernen der Maskenmaterialschicht, um eine dielektrische Schicht auf der Zielschicht und dem ringförmigen Pad zu bilden, oder nach Bildung des ringförmigen Pads, Beibehalten der Maskenmaterialschicht und Bilden einer dielektrischen Schicht auf der Maskenmaterialschicht.

5. Verfahren zum Bilden der Kontaktfensterstruktur nach Anspruch 1, wobei beim Bilden der dielektrischen Schicht die mittlere Durchkontaktierung in dem mittleren Teil des ringförmigen Pads vollständig mit der gebildeten dielektrischen Schicht gefüllt wird.

6. Verfahren zur Herstellung der Kontaktfensterstruktur nach Anspruch 1, wobei beim Bilden der dielektrischen Schicht die mittlere Durchkontaktierung teilweise mit der dielektrischen Schicht gefüllt oder nicht gefüllt wird und ein Luftspalt in dem ringförmigen Pad gebildet wird.

7. Verfahren zum Bilden der Kontaktfensterstruktur nach Anspruch 1, ferner umfassend:
vor Bilden der dielektrischen Schicht, Füllen der mittleren Durchkontaktierung in dem mittleren Teil des ringförmigen Pads mit einer Opferschicht, wobei beim Ätzen der dielektrischen Schicht, um das Ätzloch zu bilden, eine Ätzrate für die Opferschicht größer ist als eine Ätzrate für die dielektrische Schicht.

8. Verfahren zum Bilden der Kontaktfensterstruktur nach Anspruch 1, wobei die Stärke des ringförmigen Pads in radialer Richtung das Dreifache oder mehr der Größe der mittleren Durchkontaktierung ist, wobei die Größe der mittleren Durchkontaktierung ein Durchmesser der mittleren Durchkontaktierung ist.

9. Verfahren zum Bilden der Kontaktfensterstruktur nach Anspruch 1, wobei die Zielschicht in einem Prozess eines Bildens des Kontaktfensters teilweise durch Ätzen entfernt wird.

10. Verfahren zum Bilden der Kontaktfensterstruktur nach Anspruch 1, ferner umfassend: Bereitstellen eines Substrats, wobei die Zielschicht in dem Substrat gebildet wird und eine Oberfläche der Zielschicht von dem Substrat freigelegt wird.

11. Verfahren zum Bilden eines Metallstopfens, umfassend:
Bilden einer Kontaktfensterstruktur unter Verwendung des Verfahrens nach einem der Ansprüche 1 bis 10; und Füllen der Kontaktfensterstruktur mit Metall, um den Metallstopfen (214) zu bilden.

## Revendications

1. Procédé de formation d'une structure de fenêtre de contact, comprenant :
la fourniture d'une couche cible (202) ;
la formation d'un joint d'étanchéité annulaire (203) sur une surface de la couche cible, dans lequel un trou traversant central (213), à partir duquel une surface partielle de la couche cible est exposée, est formé dans une partie centrale du joint d'étanchéité annulaire ;
la formation d'une couche diélectrique (211) recouvrant la couche cible et le joint d'étanchéité annulaire ;
la gravure de la couche diélectrique pour former un trou de gravure (212) relié au trou traversant central dans la couche diélectrique ; et le retrait du joint d'étanchéité annulaire pour former la structure de fenêtre de contact.

2. Procédé de formation de la structure de fenêtre de contact selon la revendication 1, dans lequel la formation du joint d'étanchéité annulaire comprend :
la formation d'une structure en colonne (204) sur la surface partielle de la couche cible ;
la formation d'une couche de matériau de joint d'étanchéité (205) sur une paroi latérale et une surface supérieure de la structure en colonne, ainsi que sur la surface partielle de la couche cible ;
le retrait de la couche de matériau de joint d'étanchéité sur une surface supérieure de la structure en colonne et la surface partielle de la couche cible par gravure, pour former le joint d'étanchéité annulaire (203) sur une surface de la paroi latérale de la structure en colonne ; et le retrait de la structure en colonne.

3. Procédé de formation de la structure de fenêtre de contact selon la revendication 1, dans lequel la formation du joint d'étanchéité annulaire comprend :
la formation d'une couche de matériau de masque (206) sur la surface partielle de la couche cible, dans lequel un premier trou traversant (207), à partir duquel la surface partielle de la couche cible est exposée, est formé dans la couche de matériau de masque ;
la formation d'une couche de matériau de joint d'étanchéité (208) sur une paroi latérale et une surface inférieure du premier trou traversant, ainsi qu'une surface de la couche de matériau de masque ; et le retrait de la couche de matériau de joint d'étanchéité sur la surface de la couche de matériau de masque et la surface inférieure du premier trou traversant par gravure, pour former le joint d'étanchéité annulaire (203) sur une surface de la paroi latérale du premier trou traversant.

4. Procédé de formation de la structure de fenêtre de contact selon la revendication 3, comprenant en outre :
après la formation du joint d'étanchéité annulaire, le retrait de la couche de matériau de masque pour former une couche diélectrique sur la couche cible et le joint d'étanchéité annulaire, ou après la formation du joint d'étanchéité annulaire, la conservation de la couche de matériau de masque et la formation d'une couche diélectrique sur la couche de matériau de masque.

5. Procédé de formation de la structure de fenêtre de contact selon la revendication 1, dans lequel, lors de la formation de la couche diélectrique, le trou traversant central dans la partie médiane du joint d'étanchéité annulaire est entièrement rempli de la couche diélectrique formée.

6. Procédé de formation de la structure de fenêtre de contact selon la revendication 1, dans lequel, lors de la formation de la couche diélectrique, le trou traversant central est partiellement rempli ou non rempli de la couche diélectrique, et un espace d'air est formé dans le joint d'étanchéité annulaire.

7. Procédé de formation de la structure de fenêtre de contact selon la revendication 1, comprenant en outre :
avant la formation de la couche diélectrique, le remplissage du trou traversant central dans la partie médiane du joint d'étanchéité annulaire avec une couche sacrificielle, dans lequel, lors de la gravure de la couche diélectrique pour former le trou de gravure, une vitesse de gravure pour la couche sacrificielle est supérieure à une vitesse de gravure pour la couche diélectrique.

8. Procédé de formation de la structure de fenêtre de contact selon la revendication 1, dans lequel une épaisseur dans la direction radiale du joint d'étanchéité annulaire est 3 fois ou plus la taille du trou traversant central, la taille du trou traversant central étant le diamètre du trou traversant central.

9. Procédé de formation de la structure de fenêtre de contact selon la revendication 1, dans lequel, au cours du processus de formation de la fenêtre de contact, la couche cible est partiellement retirée par gravure.

10. Procédé de formation de la structure de fenêtre de contact selon la revendication 1, comprenant en outre : la fourniture d'un substrat, dans lequel la couche cible est formée dans le substrat, et une surface de la couche cible est exposée à partir du substrat.

11. Procédé de formation d'une fiche métallique, comprenant :
la formation d'une structure de fenêtre de contact en utilisant le procédé selon l'une quelconque des revendications 1 à 10 ; et le remplissage de la structure de fenêtre de contact avec du métal pour former la fiche métallique (214).
